# EUROPÄISCHE PATENTANMELDUNG

(11) **EP 0 759 558 A2**
(43) Veröffentlichungstag der Anmeldung: **26.02.1997**
(21) Anmeldenummer: 96113003.6
(22) Anmeldetag: 13.08.1996
(51) Int. Cl.: G01R 31/02

(54) **Prüfverfahren für einen Analogeingabekanal einer Analogsignalerfassungsschaltung und zugehörige Analogsignalerfassungsschaltung**

(30) Priorität: 18.08.1995 DE 19530414
(71) Anmelder: SIEMENS AKTIENGESELLSCHAFT, 80333 München (DE)
(72) Erfinder: Voigt, Stefan, 09114 Chemnitz (DE)

(57) **Zusammenfassung**

Die vorliegende Erfindung betrifft ein Prüfverfahren für einen Differenz-Analogeingabekanal (18) einer Analogsignalerfassungsschaltung, deren Signalleitungen (3,7) über einen Kondensator (11) miteinander verbunden sind. Erfindungsgemäß wird in eine der Leitungen (3) ein Teststrom eingespeist und die hierdurch verursachte Potentialdifferenzverschiebung bestimmt. Aufgrund der Größe der Potentialverschiebung läßt sich dann entscheiden, ob ein Leitungsbruch vorliegt oder nicht.

## Beschreibung

Die vorliegende Erfindung betrifft ein Prüfverfahren gemäß dem Oberbegriff des Anspruchs 1 sowie die hiermit korrespondierende Analogsignalerfassungschaltung gemäß dem Oberbegriff des Anspruchs 9.

In der deutschen Auslegeschrift 22 03 307 ist eine Anordnung zum Überwachen von Leitungsbrüchen in einem einen kleinen Innenwiderstand aufweisenden Meßkreis beschrieben, dem eine zeitweise arbeitende Weiterverarbeitungseinrichtung für die Meßsignale nachgeschaltet ist, deren Arbeitszeiten aus einer Vorbereitungszeit und einer darauffolgenden Meßzeit zusammengesetzt sind. Bei dieser bekannten Anordnung wird über einen als Konstantspannungsquelle ausgebildeten Meßwertgeber über eine erste und eine zweite Leitung einer Auswerteschaltung ein Prüfstimulus zugeführt, wobei die erste und die zweite Leitung über einen Kondensator verbunden sind, der parallel zum Eingang der Auswerteschaltung geschaltet ist.

Diese bekannte Anordnung arbeitet nun in der Weise, daß während der Meßpause der Kondensator aufgeladen wird und während der Meßphase festgestellt wird, ob sich der Kondensator über einen Meßkreis entladen hat oder nicht. Erfolgte die Entladung des Kondensators über den Meßkreis, wird dadurch die ordnungsgemäße Verbindung der Leitungen miteinander abgeleitet.

Die in der deutschen Auslegeschrift 22 03 307 beschriebene Anordnung ist insofern noch nicht ganz optimal, als zum einen das Meßergebnis durch Gleichtakt-Störspannungen verfälscht werden kann und zum anderen mit relativ großen Spannungsänderungen oder gar Übersteuerungen gearbeitet wird. Weiter ist diese bekannte Anordnung nur bedingt für relativ schnelle Analogeingänge geeignet, da die im Falle von schnell aufeinander folgenden Meßphasen am Kondensator verbleibende Ladung unter Umständen zu einer Verfälschung der Meßergebnisse führt.

Häufig ist an eine gattungsgemäße Schaltung ein Linearpotentiometer angeschlossen. Das größte Problem bei der Zuverlässigkeit von Linearpotentiometern sind Kontaktschwierigkeiten, insbesondere beim Schleiferkontakt des Potentiometers.

Bei schnellen Analogeingabekanälen wird im Stand der Technik entweder völlig auf eine Überwachung des Kanals verzichtet oder es wird ein großer Entladewiderstand zwischen den beiden Leitungen der Schaltung eingefügt. Das Verfahren ist aber ungeeignet, wenn zwischen den beiden Leitungen noch ein Kondensator angeordnet ist, da in diesem Fall die Entladezeitkonstante zu groß würde.

Die Aufgabe der vorliegenden Erfindung besteht darin, ein Verfahren und die hiermit korrespondierende Schaltung zur Verfügung zu stellen, mittels derer trotz des Vorhandenseins eines Kondensators eine Prüfung des Analogeingabekanals ermöglicht wird, die auch zur Überwachung für relativ schnelle Analogeingänge geeignet ist, wobei weiterhin eine Verfälschung der Nutz-Analogsignale durch Kompensation von Gleichtakt-Störspannungen weitgehend ausgeschlossen ist.

Dadurch, daß diese Analogsignal-Erfassungsschaltung einen Differenzverstärker aufweist, dem über seine beiden Eingänge direkt der erste bzw. der zweite Teststrom sowie außerhalb der Prüfzeit das Nutz-Analogsignal zugeführt wird, ist die Verfälschung des Testergebnisses bzw. des Meßergebnisses durch Gleichtakt-Störspannungen weitgehend ausgeschlossen, da in die erste und in die zweite Leitung eingestreute Gleichtakt-Störspannungen durch die Differenzenbildung kompensiert werden.

Bei dem erfindungsgemäßen Prüfverfahren wird während einer ersten Einspeisezeit ein erster Teststrom eingespeist und während einer zweiten Einspeisezeit ein zweiter Teststrom mit - bezogen auf den ersten Teststrom - umgekehrter Polarität eingespeist. Dies führt vorteilhafterweise dazu, daß nach Abschluß des Prüfvorganges die Spannung über dem Kondensator zumindest annähernd die gleiche ist, wie zu Beginn des Prüfvorganges, da infolge des Stromes mit entgegengesetzter Polarität während der zweiten Einspeisezeit die im Kondensator während der ersten Einspeisezeit hervorgerufene Ladung kompensiert wird. Aus diesem Grunde eignet sich das erfindungsgemäße Prüfverfahren besonders auch zur Überwachung relativ schneller Analogeingänge ohne negative Beeinflussung des Nutz-Analogsignals, da auf diese Weise eine Verfälschung der Messung des Nutz-Analogsignals durch im Kondensator verbleibende Ladung weitgehend ausgeschlossen ist.

Weiterhin ist das Prüfverfahren gemaß Anspruch 1 bzw. die hierzu korrespondierende Analog-Signalerfassungsschaltung gemäß Anspruch 9 speziell für die Beschaltung mit Linearpotentiometern konzipiert, so daß vorteilhafterweise bereits wechselnde Quellwiderstände und parasitäre Kapazitäten, vor allem parasitäre Leitungskapazitäten, berücksichtigt werden.

Die Aufgabe wird für das Verfahren bzw. die Schaltung durch die kennzeichnenden Merkmale des Anspruchs 1 bzw. des Anspruchs 9 gelöst.

Durch die Kompensation des Teststroms gemäß Anspruch 2 bzw. die hierzu korrespondierende Möglichkeit der Test-Stromquelle, auch einen Strom negativen Vorzeichens zu liefern, wird erreicht, daß das eigentliche Meßergebnis nach der Prüfung zumindest weitgehend wieder restauriert wird. Eine Optimierung bezüglich der Restaurierung des ursprünglichen Signals wird durch die Maßnahmen der Ansprüche 3 bis 5 bzw. der Ansprüche 11 und 12 geschaffen.

Weitere Vorteile und Einzelheiten ergeben sich aus der nachfolgenden Beschreibung eines Ausführungsbeispiels. Dabei zeigen:
- FIG 1: eine Analogsignalerfassungsschaltung
- FIG 2: den Stromverlauf der Test-Stromquelle der Analogsignalerfassungsschaltung und
- FIG 3: den Spannungsverlauf am Kondensator der Analogsignalerfassungsschaltung.

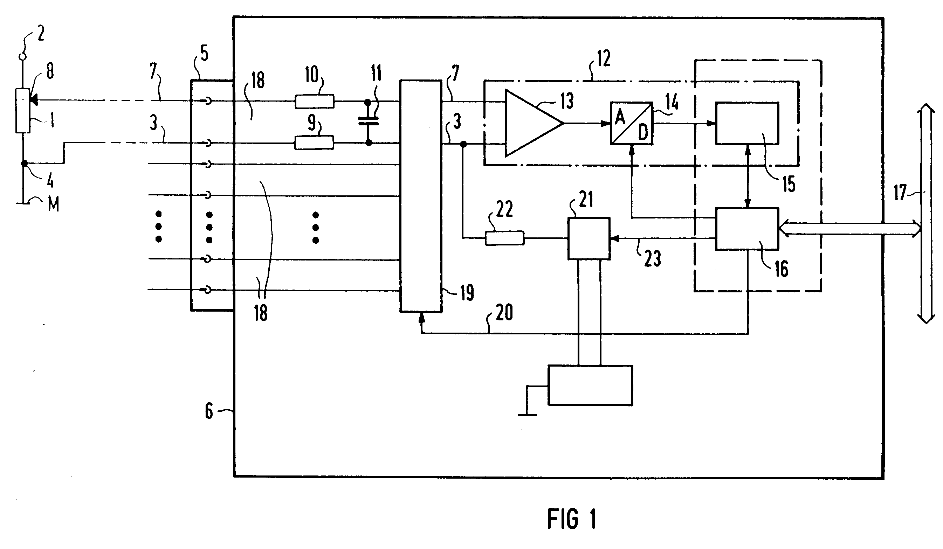

Gemäß FIG 1 ist ein aus Leitplastik bestehendes Linearpotentiometer 1 einerseits mit Masse M und andererseits mit einer Spannungsquelle 2 verbunden. Eine erste Leitung 3 ist an einem Knotenpunkt 4 mit der Masseverbindung des Potentiometers 1 verbunden und führt über einen Steckverbinder 5 zu einer Analogsignalerfassungsschaltung 6. Ebenso führt eine zweite Leitung 7 vom Schleiferkontakt 8 des Potentiometers 1 über den Steckverbinder 5 zur Analogsignalerfassungsschaltung 6.

Wie aus FIG 1 sofort ersichtlich ist, entspricht der Teil des Potentiometers 1 oberhalb der gestrichelten Linie, welche durch die Stellung des Schleiferkontakts 8 definiert ist, dem zweiten elektrischen Element. Ebenso entspricht der Teil des Potentiometers 1 unterhalb der gestrichelten Linie dem ersten elektrischen Element.

Innerhalb der Analogsignalerfassungsschaltung 6 sind, wie aus FIG 1 sofort ersichtlich, in den Leitungen 3,7 ein erster Widerstand 9 und ein zweiter Widerstand 10 angeordnet. Ferner sind die Leitungen 3 und 7 über den Kondensator 11 miteinander verbunden. Die Widerstände 9 und 10 dienen der Entkopplung der Meß- und Auswerteschaltung 12 vom Potentiometer 1. Der Kondensator 11 dient der Ausfilterung von kurzzeitigen Spannungsspitzen.

Das der Meß- und Auswerteschaltung 12 über die Leitungen 3,7 zugeführte Signal wird zunächst in einem Differenzverstärker 13 verstärkt und dann im von der Steuerschaltung 16 kontrollierten Analog-Digital-Wandler 14 digitalisiert, bevor es der digitalen Auswerteschaltung 15 zugeführt wird. Diese meldet dann das Meßergebnis weiter an die Steuerschaltung 16, welche z.B. mit einem Bus 17 verbunden ist, über welchen der Meßwert weiter an eine übergeordnete Kontrolleinheit, z.B. die Zentraleinheit einer speicherprogrammierbaren Steuerung, gemeldet wird.

Wie aus FIG 1 ersichtlich ist, sind im vorliegendem Fall die digitale Auswerteschaltung 15 und die Steuerschaltung 16 als separate Schaltungen ausgebildet. Sie könnten jedoch auch in einer gemeinsamen integrierten Schaltung, z.B. einem Mikroprozessor, angeordnet sein.

Wie ferner aus FIG 1 ersichtlich ist, weist die Analogsignalerfassungsschaltung 6 mehrere Analogeingabekanäle 18 auf, wobei jeder Kanal 18 eine erste und eine zweite Leitung aufweist. Die Kanäle 18 sind alle gleich aufgebaut. Der Übersichtlichkeit halber ist nur der oberste Kanal 18 detailliert dargestellt. Die Meß- und Auswerteschaltung 12 hingegen ist nur einmal vorhanden. Die Analogsignalerfassungsschaltung 6 weist daher einen Multiplexer 19 auf, über den die Analogeingabekanäle 18 abwechselnd mit der Meß- und Auswerteschaltung 12 verbindbar sind.

Im Normalbetrieb steuert die Steuerschaltung 16 über die Steuerleitung 20 den Multiplexer 19 derart, daß er nacheinander die Kanäle 18 mit der Meß- und Auswerteschaltung 12 verbindet. Die am jeweiligen Kanal 18 anstehende Potentialdifferenz wird dann gemessen und in der digitalen Auswerteschaltung 15 ausgewertet, gegebenenfalls auch zwischengespeichert. Wenn die Potentialdifferenz des letzten Analogeingabekanals 18 gemessen ist, wird erneut die Potentialdifferenz des ersten Analogeingabekanals 18 gemessen und somit ein neuer Meßzyklus gestartet.

Um testen zu können, ob die Leitungen 3 und 7 eines Kanals 18 ordnungsgemäß an das Potentiometer 1 angeschlossen sind und ob die Masseverbindung des Potentiometers 1 noch besteht, weist die Analogsignalerfassungsschaltung 6 eine steuerbare Test-Stromquelle 21 auf, welche über den Widerstand 22 mit der ersten Leitung 3 verbunden ist. Die Test-Stromquelle 21 ist als Konstantstromquelle ausgebildet. Sie wird über die Steuerleitung 23 von der Steuerschaltung 16 angesteuert. Sie kann z.B. wahlweise einen positiven Strom von +200µA in die Leitung 3 einspeisen oder einen negativen Strom von -140µA aus der Leitung 3 ausspeisen. Genau genommen besteht die Test-Stromquelle 21 aus zwei Konstantstromquellen welche parallel zueinander angeordnet sind. Beide sind steuerbar, wobei die eine einen positiven Strom von 200µA liefert und die andere einen negativen Strom von 340µA aufnimmt. Wenn im Ergebnis der negative Strom von 140µA aus der Leitung 3 ausgespeist werden soll, müssen also beide Stromquellen eingeschaltet werden, da die Differenz von 200µA(+) und 340µA(-) die gewünschten 140µA(-) ergibt.

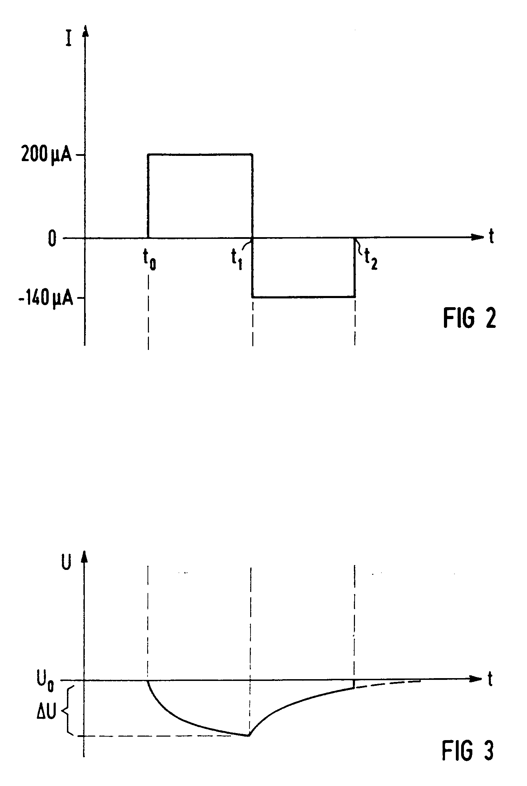

Zum Testen der Verbindungen der Leitungen 3 und 7 mit dem Potentiometer 1 wird zunächst die Potentialdifferenz zwischen den Leitungen 3 und 7 gemessen. Sodann wird - vergleiche FIG 2 - während einer ersten Einspeisezeit, welche vom Zeitpunkt t₀ bis zum Zeitpunkt t₁ reicht, ein Teststrom in Höhe von 200 µA in die erste Leitung 3 eingespeist. Zum Zeitpunkt t₁ wird in einer zweiten Messung die Potentialdifferenz zwischen den Leitungen 3 und 7 erneut gemessen.

Um sodann die durch das Prüfen der Leitungen 3,7 bewirkte Verfälschung des Meßergebnisses möglichst schnell wieder zu kompensieren, wird nach der zweiten Messung während einer zweiten Einspeisezeit ein negativer Kompensationsstrom von -140µA aus der ersten Leitung 3 ausgespeist.

Zum Zeitpunkt t₂ wird in einer dritten Messung die Potentialdifferenz zwischen den Leitungen 3 und 7 nochmals gemessen.

Anhand der Unterschiede der Potentialdifferenzen, die mit den Messungen zum Zeitpunkt t₀, t₁ und t₂ ermittelt wurden, wird dann entschieden, ob die Leitungen 3,7 ordnungsggemäß miteinander und mit den Versorgungspotentialen, also der Spannungsquelle 2 und Masse M, verbudnen sind. Bei ordnungsgemäßer Verbindung der Leitungen 3 und 7 mit dem Potentiometer 1 ändert sich die Spannung U des Kondensators bis zum Zeitpunkt t₁ um den Betrag ΔU. Bis zum Zeitpunkt t₂ ist die diese Spannung hervorrufende Ladung des Kondensators durch den Kompensationsstrom wieder weitgehend abgebaut. Dieser Fall ist in FIG 3 dargestellt.

Ein besonderer Vorteil des erfindungsgemäßen Prüfverfahrens besteht darin, daß alternativ zu dem Potentialdifferenzen zu den Zeitpunkten t₀, t₁ und t₂ z.B. auch die Potentialdifferenzen zum Zeitpunkt t₀ und t₂ oder zum Zeitpunkt t₀ und t₁ zur Prüfung des Analogeingabekanals herangezogen werden können. Das erfindungsgemäße Prüfverfahren kann also mit 3 oder 2, erforderlichefalls sogar mit nur einem Meßwert ausgeführt werden. Als weitere Alternative bietet sich z.B. eine Mittelwertbildung dreier oder zweier Potentialdifferenzen an.

Die zweite Einspeisezeit, d. h. der Abschnitt zwischen den Zeitpunkt t₁ und t₂, ist dabei gleich der ersten Einspeisezeit. Aufgrund der Restströme, welche mittels der Masseverbindung fließen, muß der Kompensationsstrom nicht genau so groß sein wie der Teststrom. Er sollte aber betragsmäßig im Bereich zwischen 60 und 75% des Teststromes liegen. Die erste Einspeisezeit und die zweite Einspeisezeit liegen in der Größenordnung deutlich unterhalb einer ms, beispielsweise bei je ca. 150µs.

Selbstverständlich darf der Meßzyklus nicht unterbrochen werden. Es darf also nicht auf einen anderen Analogeingabekanal 18 umgeschaltet werden, während ein Meßzyklus läuft.

Wenn das Potentiometer 1 ordnungsgemäß mit der Spannungsquelle 2, Masse M und den Leitungen 3,7 verbunden ist, fließt ein Teil des Teststromes auf den Kondensator 11, ein anderer Teil über den Widerstand 9 auf Masse M und ein wieder anderer Teil über den Widerstand 9, das Potentiometer 1 und den Widerstand 10 auf den Kondensator 11. Der über den Widerstand 10 auf den Kondensator 11 fließende Strom ist dabei geringer als der direkt auf den Kondensator 11 fließende Strom. In der Folge ergibt sich demnach eine Absenkung der Potentialdifferenz U um ΔU.

Wenn hingegen die Leitung 7 unterbrochen ist oder der Schleiferkontakt 8 des Potentiometers 1 nicht mehr ordnungsgemäß funktioniert, ist die zweite Leitung 7 praktisch isoliert von der ersten Leitung 3. Die sich auf dem Kondensator 11 befindliche Ladung und damit auch die Kondensatorspannung U können sich folglich nicht mehr ändern. Trotz Einspeisen eines Teststroms über den Widerstand 22 ändert sich also die Potentialdifferenz zwischen zwei Messungen gar nicht oder nur sehr wenig. Wenn hingegen die Leitung 3 unterbrochen ist, kann kein Strom über den Widerstand 9 fließen. Der gesamte eingespeiste Teststrom muß auf den Kondensator 11 fließen. In der Folge ergibt sich eine sehr hohe Potentialdifferenzänderung zwischen zwei Messungen. Wenn die Verbindung des Potentiometers 1 zu Masse unterbrochen ist, fließt ebenfalls der eingespeiste Teststrom im wesentlichen auf den Kondensator 11. Auch in diesem Fall ergibt sich also eine sehr große Spannungsänderung.

Im Ergebnis ist also festzustellen, daß die Leitungen 3,7 ordnungsgemäß mit dem Potentiometer 1 verbunden sind, wenn die Spannungsdifferenz zwischen zwei Messungen oberhalb einer unteren Schranke und unterhalb einer oberen Schranke liegt. Sinnvolle Werte für die obere und die untere Schranke können experimentell vorab bestimmt werden und beispielsweise in einem Festwertspeicher, insbesondere einem EEPROM hinterlegt werden. Der Festwertspeicher ist mit der digitalen Auswerteschaltung 15 verbunden, der die obere und die untere Schranke nach Bedarf aus dem Festwertspeicher abrufen kann. Bei der Festlegung der Werte für die obere und die untere Schranke können insbesondere die Streuungen der einzelnen Bauelemente und die Toleranzen berücksichtigt werden.

Wenn ein Leitungsfehler detektiert wird, kann dies im Extremfall auf einem einzelnen "Ausreißer" beruhen. Zur Sicherheit ist daher zu empfehlen, beim Detektieren eines Leitungsfehlers sofort einen zweiten Meßzyklus durchzuführen, so daß derartige "Ausreißer" praktisch auszuschließen sind.

Wie bereits erwähnt, erfolgt die Auswertung der Meßwerte in der digitalen Auswerteschaltung 15. Um die Auswertung möglichst schnell durchführen zu können, weist die digitale Auswerteschaltung 15 daher ein Rechenwerk auf, welches insbesondere eine schnelle Multiplikation und eine schnelle Division durchführen kann. Die digitale Auswerteschaltung kann beispielsweise Bestandteil eines Mikroprozessors mit entsprechenden Rechenschaltungen sein.

Hinsichtlich des Innenwiderstandes des Meßwertgebers, also des Linearpotentiometers, besteht keine strikte Forderung, daß dieser so klein wie möglich sein sollte, allerdings sollte in der Praxis eine Obergrenze von 2,5 kΩ auch nicht überschritten werden.

## Patentansprüche

1. Prüfverfahren für einen Analogeingabekanal einer Analogsignalerfassungsschaltung,
- wobei die Analogsignalerfassungsschaltung eine Meß- und Auswerteschaltung aufweist, der über eine erste und eine zweite Leitung von außerhalb der Analogsignalerfassungsschaltung ein erstes und ein zweites Spannungssignal zuführbar sind,
- wobei die erste Leitung und die zweite Leitung innerhalb der Analogsignalerfassungsschaltung über einen Kondensator miteinander verbunden sind und außerhalb der Analogsignalerfassungsschaltung über ein erstes elektrisches Element miteinander verbunden sein sollten,
- wobei die erste Leitung außerhalb der Analogsignalerfassungsschaltung mit einem ersten Versorgungspotential verbunden sein sollte,
- wobei die zweite Leitung außerhalb der Schaltung über ein zweites elektrisches Element mit einem zweiten Versorgungspotential verbunden sein sollte,
**dadurch gekennzeichnet,**
- daß zunächst die Potentialdifferenz zwischen den Leitungen (3,7) gemessen wird,
- daß sodann in die erste Leitung (3) während einer Einspeisezeit ein Teststrom eingespeist wird,
- daß sodann erneut die Potentialdifferenz zwischen den Leitungen (3,7) gemessen wird und
- daß schließlich anhand des Unterschiedes der Potentialdifferenzen entschieden wird, ob die Leitungen (3,7) ordnungsgemäß miteinander und mit den Versorgungspotentialen verbunden sind oder nicht.

2. Prüfverfahren nach Anspruch 1, **dadurch gekennzeichnet,** daß zur Kompensation der mittels des Teststromes in die erste Leitung (3) eingespeisten Ladung nach der erneuten Messung während einer Ausspeisezeit ein Kompensationsstrom aus der ersten Leitung ausgespeist wird.

3. Prüfverfahren nach Anspruch 2, **dadurch gekennzeichnet,** daß die Einspeisezeit gleich der Ausspeisezeit ist.

4. Prüfverfahren nach einem der obigen Ansprüche, **dadurch gekennzeichnet,** daß sowohl der Teststrom als auch der Kompensationsstrom während der Einspeise- bzw. Ausspeisezeit konstant ist.

5. Prüfverfahren nach Anspruch 4, **dadurch gekennzeichnet,** daß der Betrag des Kompensationsstromes kleiner als der Betrag des Teststromes ist, insbesondere daß der Betrag des Kompensationsstromes zwischen 60 und 75% des Betrages des Teststromes liegt.

6. Prüfverfahren nach einem der obigen Ansprüche, **dadurch gekennzeichnet,** daß bei Detektieren einer nicht ordnungsgemäßen Verbindung der Leitungen (3,7) miteinander oder mit den Versorgungspotentialen zur Überprüfung sofort ein zweiter Meßzyklus durchgeführt wird.

7. Prüfverfahren nach einem der obigen Ansprüche, **dadurch gekennzeichnet,** daß nur dann auf ordnungsgemäße Verbindung der Leitungen (3,7) miteinander und mit den Versorgungspotentialen erkannt wird, wenn der Unterschied der Potentialdifferenzen zwischen einer unteren Schranke und einer oberen Schranke liegt.

8. Prüfverfahren nach Anspruch 7, **dadurch gekennzeichnet,** daß die obere und die untere Schranke aus einem elektrisch löschbaren und überschreibbaren Festwertspeicher abgerufen werden.

9. Analogsignalerfassungsschaltung,
- wobei die Analogsignalerfassungsschaltung eine Meß- und Auswerteschaltung aufweist, der über eine erste und eine zweite Leitung von außerhalb der Analogsignalerfassungsschaltung ein erstes und ein zweites Spannungssignal zuführbar sind, so daß von der Meß- und Auswerteschaltung die Potentialdifferenz zwischen den Leitungen meßbar und auswertbar ist,
- wobei die erste Leitung und die zweite Leitung innerhalb der Analogsignalerfassungsschaltung über einen Kondensator miteinander verbunden sind,
**dadurch gekennzeichnet,**
- daß die Analogsignalerfassungsschaltung (6) eine steuerbare Test-Stromquelle (21) aufweist, die zur Stromeinspeisung mit der ersten Leitung (3) verbunden ist,
- daß die Analogsignalerfassungsschaltung (6) eine mit der Test-Stromquelle (21) verbundene Steuerschaltung (16) zum Ansteuern der Test-Stromquelle (21) aufweist und
- daß die Steuerschaltung (21) auch mit der Meß- und Auswerteschaltung (12) gekoppelt ist.

10. Analogsignalerfassungschaltung nach Anspruch 9, **dadurch gekennzeichnet,** daß die Test-Stromquelle (21) derart ausgebildet ist, daß sie sowohl einen Strom positiven Vorzeichens als auch einen Strom negativen Vorzeichens liefern kann.

11. Analogsignalerfassungschaltung nach Anspruch 9 oder 10, **dadurch gekennzeichnet,** daß die Test-Stromquelle (21) als Konstantstromquelle ausgebildet ist.

12. Analogsignalerfassungschaltung nach Anspruch 10 und 11, **dadurch gekennzeichnet,** daß der Strom negativen Vorzeichens betragsmäßig kleiner als der Strom positiven Vorzeichens ist, insbesondere zwischen 60 und 75% des Betrages des positiven Stromes liegt.

13. Analogsignalerfassungschaltung nach einem der Ansprüche 9 bis 12, **dadurch gekennzeichnet,** daß in der ersten Leitung (3), von der Meß- und Auswerteschaltung (12) aus gesehen, hinter dem Einspeisepunkt für die Test-Stromquelle (21) und dem Anschlußpunkt für den Kondensator (11) ein erster Widerstand (9) angeordnet ist.

14. Analogsignalerfassungschaltung nach einem der Ansprüche 9 bis 13, **dadurch gekennzeichnet,** daß in der zweiten Leitung (7), von der Meß- und Auswerteschaltung (12) ausgesehen, hinter dem Anschlußpunkt des Kondensators (11) ein zweiter Widerstand (10) angeordnet ist.

15. Analogsignalerfassungschaltung nach einem der Ansprüche 9 bis 14, **dadurch gekennzeichnet,**
- daß sie mehrere Paare (18) von ersten und zweiten Leitungen (3,7) aufweist, die jeweils über einen eigenen Kondensator (11) miteinander verbunden sind und in denen gegebenenfalls jeweils erste und zweite Widerstände (9,10) angeordnet sind,
- daß der Einspeisepunkt für die Test-Stromquelle (21), von der Meß- und Auswerteschaltung (12) gesehen, vor den Anschlußpunkten der Kondensatoren (11) an die ersten Leitungen (3) angeordnet ist,
- daß die Analogsignalerfassungschaltung (6) einen Multiplexer (19) aufweist, über den die Leitungspaare (18) abwechselnd mit der Meß- und Auswerteschaltung (12) verbindbar sind, und
- daß der Multiplexer (19) bezüglich der zweiten Leitung (7) zwischen dem jeweiligen Anschlußpunkt des Kondensators (11) und der Meß- und Auswerteschaltung (12) und bezüglich der ersten Leitung (3) zwischen dem jeweiligen Anschlußpunkt des Kondensators (11) und dem Ein- bzw. Ein/Ausspeisepunkt der Test-Stromquelle (21) angeordnet ist.

16. Analogsignalerfassungschaltung nach einem der Ansprüche 9 bis 15, **dadurch gekennzeichnet,** daß das der Meß- und Auswerteschaltung (12) zugeführte Signal innerhalb der Meß- und Auswerteschaltung (12) zunächst einem Differenzverstärker (13) zugeführt wird, dessen Ausgangssignal einem Analog-Digital-Wandler (14) zugeführt wird, dessen Ausgangssignal einer digitalen Auswerteschaltung (15) zugeführt wird.

17. Analogsignalerfassungschaltung nach Anspruch 16, **dadurch gekennzeichnet,** daß die digitale Auswerteschaltung (15) ein Rechenwerk zur schnellen Multiplikation und Division aufweist.

18. Analogsignalerfassungschaltung nach Anspruch 16 oder 17, **dadurch gekennzeichnet,** daß sie einen elektrisch lösch- und überschreibbaren Festwertspeicher aufweist, der zur Speicherung einer oberen und einer unteren Schranke dient und mit der digitalen Auswerteschaltung (15) verbunden ist.

19. Analogsignalerfassungschaltung nach einem der Ansprüche 9 bis 18, **dadurch gekennzeichnet,** daß sie zur Detektion von Leitungsbrüchen bei Linearpotentiometern (1) verwendet wird.
